Europäisches Patentamt

European Patent Office

Office européen des brevets

(11) Publication number: **0 180 383**
A2

# EUROPEAN PATENT APPLICATION

(21) Application number: 85307507.5

(22) Date of filing: 17.10.85

(51) Int. Cl.⁴: **B 29 C 45/16,** B 29 C 45/00, H 05 K 9/00

(30) Priority: 26.10.84 US 665102

(43) Date of publication of application: 07.05.86 Bulletin 86/19

(84) Designated Contracting States: DE FR GB

(71) Applicant: ARONKASEI CO., LIMITED, 1-4-8 Tosabori, Nishi-ku Osaka (JP)

(72) Inventor: Hasegawa, Tadashi, 2603 Ebiyama-cho Tenpaku-ku, Nagoya (JP)
Inventor: Haga, Kazuo, 11-9 Kaminoyama Narumi-cho, Midori-ku Nagoya (JP)
Inventor: Izumo, Kazuyuki, 1-13 Sagarimatsu Arao-cho, Tokai Aichi Prefecture (JP)
Inventor: Sugie, Nobuyoshi, 55-8 Torayama Hatsuka-cho, Nishio Aichi Prefecture (JP)
Inventor: Enomoto, Katsuyuki, 1-5 Sagarimatsu Arao-cho, Tokai Aichi Prefecture (JP)

(74) Representative: Myerscough, Philip Boyd et al, J.A.Kemp & Co. 14, South Square Gray's Inn, London, WC1R 5EU (GB)

(54) A manufacturing method for housings with a two-layer structure.

(57) Housings (122) having a two-layer structure are made by injection-molding a first layer (120) using a thermoplastic resin in which metal filler is mixed and then injection-molding a second layer (124) using a thermoplastic resin in which no electrically conductive filler is mixed, keeping the temperature of said first layer within 30°C of the softening point. The resulting housings have excellent electromagnetic shielding properties.

EP 0 180 383 A2

- 1 -

A MANUFACTURING METHOD FOR HOUSINGS WITH A TWO-LAYER STRUCTURE

The present invention relates to the manufacture of housings having a two-layer structure intended mainly for use in housing electric articles and electronic instruments.

The present invention thus provides a method for the manufacture of housings having a two-layer structure which method comprises injection-molding a first layer using a thermoplastic resin in which a metal filler is mixed and then injection-molding a second layer using a thermoplastic resin in which no electric conductive fillers is mixed, while keeping the temperature of the first layer within $30^{\circ}C$ of its softening point.

One preferred form of metal filler for the first layer is metal fiber having a diameter from 5 to 100 micrometres and a length from 1 mm to 10 mm. Another preferred form of filler for the first layer is metal flake having shortest dimension and longest dimension from 0.5 mm to 3 mm, respectively, and a thickness from 10 to 100 micrometres.

- 2 -

Recently, thanks to remarkable developments in electronics including the development of, for example, the IC and LSI digital instruments using an IC or LSI, such as the computer, the electronic game machine, the television game machine, the switching electric power source of the electronic cash register, the digital clock, the desk electric computer and the word processor have become widespread. Said electric articles and electronic instruments advantageously use plastics as materials of their housings because the housings using plastics as the materials are easily mass-produced, because plastics have an excellent moldability and processability and have good insulating property.

On the other hand, digital instruments generate an electromagnetic wave of more than 10,000 pulse/sec to the space and said electromagnetic wave may disturb satisfactory radio, TV and wireless telegraph reception because plastics as materials for housings can transmit the electromagnetic wave and therefore the problem of shielding from the electromagnetic wave has become important to protect against the disturbance of the electromagnetic wave.

Hitherto, the use of thermoplastic resins mixed with metal filler has been studied as the material of housings. Nevertheless, said plastics have such disadvantages that the metal filler in the plastics may be exposed at the surface of molded housings, so that the appearance of housings becomes inferior, and such properties as mechanical strength and insulation resistance decrease. Formerly, housings consisting of a first layer made of thermoplastic resin(s) in which metal filler is mixed and a second layer made of thermoplastic resin(s) in which no electric conductive filler including metal filler is mixed have been provided by the inventors of the present invention. Said housings have a desirable appearance because of the presence of the second layer as an outer layer and a desirable electromagnetic shielding effectiveness because of the presence of the first layer as the inner layer. In said two layers structure, it may be necessary that the two layers are strongly bonded each other to prevent delamination, and further it may be necessary to prevent warpage of the resulting housings.

Accordingly, the present invention seeks to provide housings having a two-layer structure in which said two layers are strongly bonded to each other to prevent delamination.

– 4 –

Another object of the present invention is to prevent warpage of the housings.

Further object of the present invention is to provide housings having a two-layer structure which possess an excellent electromagnetic shielding effectiveness.

Still further object of the present invention is to provide metal filler(s) which provide(s) an excellent electromagnetic shielding effectiveness to the housings.

Said objects can be attained by a manufacturing method of housings having a two layer structure which comprises injection molding first layer by using thermoplastic resin(s) in which metal filler(s) is (are) mixed and then injection molding second layer by using thermoplastic resin(s) while keeping temperature of said first layer in the range of the softening point of $\pm 30^{\circ}$C, and further selecting metal fiber(s) having a diameter from 5 $\mu$m to 100 $\mu$m and a length from 1 mm to 10 mm or metal flake(s) having shortest dimension and longest dimension from 0.5 mm to 3 mm, respectively, and a thickness from 10 $\mu$m to 100 $\mu$m as said metal filler(s).

BRIEF DESCRIPTION OF THE DRAWINGS

Figure 1 shows a side view of the main part of an embodiment of the injection molding machine used in the present invention;

Figure 2 shows a vertical sectional view of the

- 5 -

main part of the embodiment; and

Figure 3 shows a sectional view of an embodiment of the housings in the present invention.

## DETAILED DESCRIPTION

The present invention relates to a manufacturing method of housings having a two layer structure which comprises injection molding first layer by using thermoplastic resin(s) in which metal filler(s) is (are) mixed and then injection molding second layer by using thermoplastic resin(s) while keeping the temperature of said first layer in the range of the softening point of $\pm 30^{\circ}C$.

Said thermoplastic resin(s) used as material(s) of said first layer and second layer may be such as polyvinylchloride, polyamide, acrylonitrile-butadiene-styrene copolymer (ABS), polystyrene, polyphenylene-oxide, polypropylene, polyethylene, polycarbonate and the like. Said metal filler(s) is (are) mixed to the thermoplastic resin (resin A) in said first layer and no electric conductive fillers including metal filler are mixed to the thermoplastic resin (resin B) in said second layer.

Desirable combinations of the resin A and the resin B for injection molding, compatibility between the resin A and the resin B and the like are shown in Table 1.

0180383

− 6 −

| Resin A | Resin B |
| --- | --- |
| Polystyrene | Polystyrene |
| Polystyrene | Polyphenylene-oxide |
| ABS | ABS |
| ABS | Polycarbonate |
| ABS | Polyvinylchloride |
| Polyamide | Polyamide |
| Polycarbonate | ABS |
| Polycarbonate | Polycarbonate |
| Polypropylene | Polyethylene |
| Polypropylene | Polypropylene |
| Polyphenylene-oxide | Polystyrene |
| Polyvinylchloride | ABS |
| Polyvinylchloride | Polymethylmethacrylate |
| Polyvinylchloride | Polyvinylchloride |

Table 1

Said metal filler(s) may be metal and/or alloy such as silver, copper, nickel, aluminum, stainless steel and the like. Said metal filler(s) is (are) provided in the form of powder, flake, fiber and the like.

Further, metal coated fiber(s) such as aluminum coated glass fiber, silver coated glass fiber and the like is (are) also used as the filler(s). Desirable forms of the filler for the electromagnetic shielding effectiveness may be fiber or flake since the filler having a form of fiber or flake is easy to contact each other and to form contineous structure of an electric conductor in the first layer and so that excellent conductivity, namely an excellent electromagnetic shielding effectiveness, of the first layer may be obtained in a 'small content of said filler(s). The desirable size of the fiber may be from 5 μm to 100 μm in a diameter and from 1 mm to 10 mm in a length. If the fiber has a diameter less than 5 m and a length more than 10 mm, the fiber will be apt to be knotted and tangled to disturb smooth mixing with the resin A and further reduce moldability of mixture of the resin A and metal filler(s).

On the other hand, if the fiber has a diameter more than 100 μm and a length less than 1 mm, closeness of the contact of the fiber to each other may be reduced, and accordingly an electromagnetic shielding effectiveness of the first layer may be reduced. Said metal fiber may be manufactured by grinding method with micro-vibrating blade, melting and rapid cooling method, pultrusion method and the like.

Following pultrusion method may be desirable in the instant invention: Namely, in the first stage, metal fiber is manufactured by the pultrusion and about 5μ to 80μ of the resulting metal fibers are bundled in the second stage. In the third stage, said bundle of metal fibers is coated by elastomer(s) or plastic modified plastic(s). Said elastomer may be such as styrene-butadiene-styrene block copolymer, styrene-ethylbutylene and the like. Said coating is commonly carried out by using the extruder attached to the crosshead die. In the forth stage, said coated bundle

— 8 —

of metal fiber(s) is cut by the cutting machine such as the pelletizer in a length from about 2 mm to 10 mm. Resulting coated and cut bundle of metal fiber(s) is mixed with the resin A.

In the above described method, knotting and tangling of metal fiber are effectively prevented by the coating of the elastomer(s) and metal fiber having diameter less than 5 $\mu$m and a length more than 10 mm can be used as metal filler of the instant invention, and further the following advantages may be considered.

1. Destruction of the metal fiber may be effectively prevented by the coating of the thermoplastic resin during mixing with the thermoplastic resin and the metal fiber can keep desirable length for electromagnetic shielding effectiveness.

2. In mixing with the resin A(s), the elastomers(s) as coating of the bundle of metal fiber(s) is softened prior to the softening of the resin A and the bundled metal fibers are smoothly unbundled to be uniformly mixed with the resin A.

3. Usually the impact strength of the thermoplastic resin is reduced by mixing filler such as metal fiber. Nevertheless, mixed elastomer(s) may increase impact strength of the thermoplastic resin without adding agents for impact strength improvement.

One or more kinds of the filler may be mixed to the resin A and the mixing amount of the filler may be controlled depending on the kind of the resin A, the kind

of the filler, the combination between the resin A and the filler, the necessary fluidity of the resin A, the necessary electromagnetic.shielding effectiveness of the resultant housings and the like. Generally, desirable the mixing amount of the metal filler may be from 1 to 20 volume %, because when the mixing amount of the filler is less than 1 volume %, the electromagnetic shielding effectiveness of the resultant housings may be reduced, while the mixing amount of the filler is more than 20 volume %, the the fluidity of the resin A may decrease and it may be difficult to obtain a good uniformity of the filler in the resin A. In particular, the desirable mixing amount of the metal fiber(s) and/or metal flake(s) may be from 1 to 5 volume %. Typical examples of combination of the filler and the resin A are shown in Table 2.

| Resin A / Filler | Polystyrene | Polystyrene | ABS | ABS | Polyphenylene-oxide |
|---|---|---|---|---|---|
| Brass fiber | 3 | 5 | — | 2 | — |
| Aluminum flake | — | — | 13 | 8 | — |
| Aluminum fiber | 4 | — | 2 | — | — |
| Copper fiber | — | — | — | — | 2 |

Table 2

(Numerals in Table 2 show volume % of the filler)

The housings having a two-layer structure of the instant invention is manufactured by the two color

- 10 -

injection molding machine. Namely, the first layer is injection-molded by using the thermoplastic resin(s) in which metal filler(s) is (are) mixed and then the second layer is injection-molded by using the thermoplastic resin(s) in which no electro conductive fillers are mixed. During said second injection-molding, it may be necessary to keep the temperature of the first layer molded in the range of the softening point of $\pm 30^{\circ}C$. In this temperature range, the resulting housings may not warp and the two layers of the housings are strongly bonded to each other. If the temperature of the first layer molded is less than the softening point $-30^{\circ}C$, during the second injection-molding, strong bonding of the two layers may not be obtained and if the temperature of the first layer molded is above the softening point of $+30^{\circ}C$, the first layer molded may be deformed during the second injection-molding.

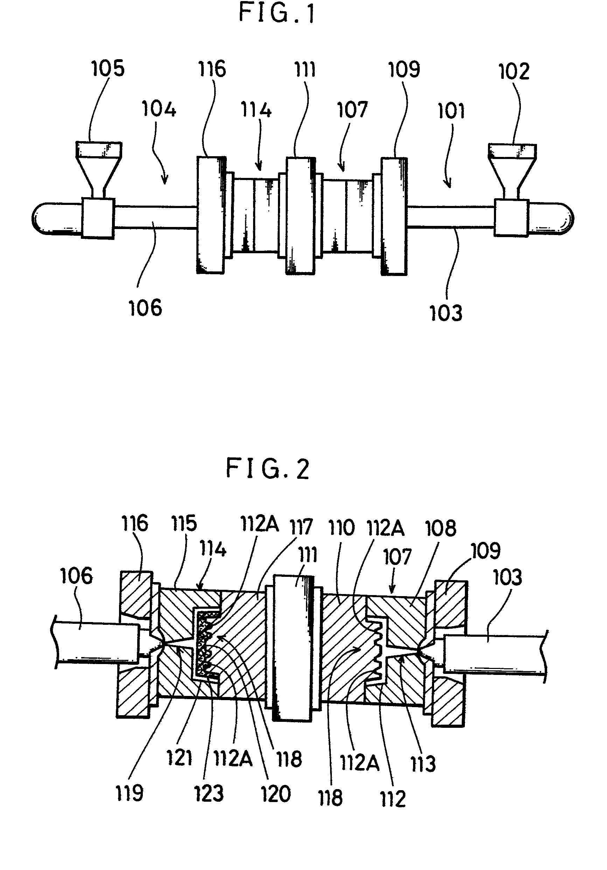

The two-color injection molding machine shown in Figs. 1 and 2 is advantageously used in the present invention. The resin A is combined according to such as the examples shown in Table 2 and uniformly mixed by the extruder to produce a compound.

Referring to Figures, said compound is charged into a hopper (102) of a primary injection-molding unit (101) and softened in a cylinder (103) by heating. On the other hand, the resin B selected according to such as the combinations shown in Table 1 is charged into a hopper (105) of a secondary injection-molding unit (104) and softened in a cylinder (106). As shown in Fig. 2, a primary injection

mold (107) consists of a primary movable injection mold part (108) fixed on a primary movable die-plate (109), and a primary fixed injection mold part (110) fixed on a rotating die-plate (111) which is horizontally rotatable. A cavity (112) having boss parts (112A) for molding of one layer is formed between the primary movable injection mold part (108) and the primary fixed injection mold part (110) and a direct gate (113) connects the cavity (112) with the cylinder (103). A secondary injection mold (114) consists of a secondary movable injection mold part (115) fixed on a secondary movable die-plate (116), and a secondary fixed injection mold part (117) fixed on the rotating die-plate (111). Both core parts (118), (118) of the primary fixed injection mold part (110) and the secondary fixed injection mold part (117) have respectively the same shape and size. A cavity (121) for molding of the other layer is formed between the secondary movable injection mold part (115) and the secondary fixed injection mold part (117), and the depth of the cavity (121) is larger than that of the cavity (112) by the thickness of one layer. A direct gate (119) connects the cavity (121) with the cylinder (106).

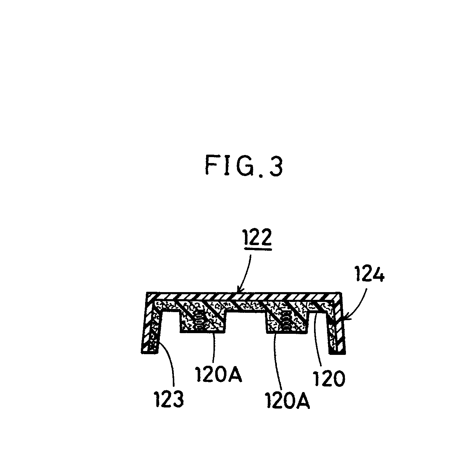

The resin A mixed with the metal fillers (123) is softened in the cylinder (103) as above described and injected into the cavity (112) through the direct gate (113) to mold the first layer (120) having bosses (120A), (120A). After a proper cooling time (after the cooling time, the temperature of the first layer (120) molded should be kept with in the range of the softening point ($\pm 30^{\circ}$C), the primary movable injection mold part (108) is separated from the primary fixed injection mold part (110) and the molding material in the direct gate (113) is cut from the resulting first layer (120) molded, and then the rotating die-plate (111) is rotated at an angle of 180° with the primary fixed injection mold part (110) to combine the primary fixed injection mold part (110) with the secondary movable injection mold part (115). The cavity (121) is thus formed between the primary fixed injection mold part (110) and the secondary movable injection mold part (115) and the layer (120) is to be inserted in the cavity (121). On the other hand, the secondary fixed injection mold part (117) is also rotated at the same time to combine with the primary movable injection mold part (108) and the cavity (112) having boss parts (112A) is also formed between the secondary fixed injection mold part (117) and the primary movable injection mold part (108). After the mold clamping, the resin B softened in the cylinder (106) is injected into the cavity (112) through the direct gate (119) to mold the second layer (124). After a proper cooling time, the primary movable injection mold part (108) is separated from the secondary fixed injection mold part (117) and the molding material in the. direct gate (119) is cut from the mold (122), and thus the mold (122) shown in Fig. 3 is obtained. In the mold (122), the layer (120) and the layer (124) are reciprocally combined into one body.

In the above described embodiment, the injection mold has the direct gate, but the fan gate, the tunnel gate and the like may be applied to the resin A for injection molding and any type of already known gate including the direct gate may be applied to the resin B for injection molding in another embodiment.

/

0180383

- 13 -

Example 1

The following components were mixed together in the extruder to prepare the resin A:

ABS (softening point 90°C)     97 volume %

Copper fiber (diameter 50 μm)  3 volume %
            (length    10 mm)

Said mixture was extruded from the extruder and then cut to produce the pelletized compound of the resin A. Said compound of the resin A was injected into the cavity (112) of the primary injection molding unit (101) through the direct gate (113) and the first layer (120) having the box form, thickness 3 mm, length 247 mm, width 197mm, height 28.5 mm was molded. After a proper cooling time, the primary movable injection mold part (108) was separated from the primary fixed injection mold part (110) and the molding material in the direct gate (113) was cut from the resulting first layer (120) molded, and then the rotating die-plate (111) was rotated to combine with the secondary movable injection mold part (115).

White-colored ABS as the resin B was then injected into the cavity (121) inserted the first layer (120) while keeping the temperature of the first layer *at 90°C* and the second layer (124), thickness 1.5 mm, was molded. The condition of the injection molding was shown as follows:

- 14 -
Primary injection molding unit:

The temperature of the mold: 60°C

The pressure of the injection: 1200 kg/cm$^2$

The temperature of the injection molding: 230°C

The time of the injection: 2 sec.

Secondary injection molding unit:

The temperature of the mold: 60°C

The pressure of the injection: 1000 kg/cm$^2$

The temperature of the injection molding: 220°C

The time of the injection: 1.5 sec.

The resulting housing had the box form, thickness 4.5 mm, length 250 mm, width 200 mm, height 30 mm. In the housing the first layer (120) as the inner layer and the second layer (124) as the outer layer were strongly bonded to each other and the housing had the desirable mechanical strength and insulation resistance, and further, the housing had the excellent electromagnetic shielding effectiveness and was useful for the housing of the digital instruments. Namely, the housing showed 40 dB for 100 MHz of the electromagnetic wave in the electromagnetic shielding effectiveness.

Example 2

A compound of the resin A having the following components was injected into the cavity (112) of the primary injection molding unit of the three plate injection mold and the first layer (120) having the box form, thickness 3.5 mm, length 397 mm, width 297 mm, height 43.5mm, was molded.

Polystyrene (softening point 90°C)   93 volume %

Brass fiber (diameter 40 µm)
        (length    3 mm)         3 volume %

Aluminum fiber (diameter 50 µm)
        (length    3 mm)         4 volume %

After a proper cooling time, the primary movable injection mold part was separated from the primary fixed injection mold part and at the same time, the molding material in the direct gate was cut from the first layer (120) molded because the two-pin point gate was provided in the injection mold, and then the rotating die-plate was rotated to combine with the secondary movable injection mold part. Brown-colored polystyrene (the resin B, softening point 90°C) was injected into the cavity of the secondary injection molding unit in which the layer (120) is molded while keeping the temperature of the first layer at 100°C. Thus the layer (124), thickness 1.5 mm, was molded. The condition of the injection molding was shown as follows:

Primary injection molding unit:

The temperature of the mold; 80°C

The pressure of the injection; 1000 kg/cm$^2$

The temperature of the injection molding; 210°C

The time of the injection; 3 sec.

- 16 -

Secondary injection molding unit:

The temperature of the mold; $50^\circ C$

The pressure of the injection; 1100 kg/cm$^2$

The temperature of the injection molding; $210^\circ C$

The time of the injection; 2 sec.

A resulting housing had the box form, thickness 5 mm, length 400 mm, width 300mm, height 50 mm, and had the desirable mechanical strength and insulation resistance.

Example 3

Brass fiber having diameter of 50 µm was manufactured by the pultrusion and said 300 brass fibers were bundled. Said bundle was passed through the cross head die of the extruder to coat styrene-butadiene-styrene block copolymer on the circumference of the bundle. The weight ratio of the brass fiber and the styrene-butadiene-styrene block copolymer was 65:35. The bundle coated by the styrene-butadiene-styrene block copolymer is cut in the length of 10 mm by the pelletized having rotatory blade. 70 weight parts of the resulting coated and cut bundle of brass fiber was mixed with 100 weight parts of ABS (softening point $90^\circ C$). As the result, the softening point of the resin A as the mixture of ABS and styrene-butadiene-styrene block copolymer was $80^\circ C$. Said mixture was extruded from the extruder and then cut to produce the pelletized compound of the resin A. Said compound of the resin A was injected into the cavity (112) of the primary injection molding unit (101) through the direct gate (113) and the first layer (120)

having the box form, thickness 3 mm, length 247 mm, width 197 mm, height 28.5 mm, was molded.  After a proper cooling time, the primary movable injection mold part (108) was separated from the primary fixed injection mold part (110) and the molding material in the direct gate (113) was cut from the resulting first layer (120) molded, and then the rotating die-plate (11) was rotated to combine with the secondary movable injection  mold part (115).

White-colored ABS as the resin B was then injected into the cavity (121) in which the first layer (120) was molded while keeping the temperature of the first layer at 80°C and the second layer (124), thickness 1.5 mm, was molded. The condition of the injection molding is shown as follows:

Primary injection molding unit:

The temperature of the mold; 80°C

The pressure of the injection; 1200 kg/cm$^2$

The temperature of the injection molding; 230°C

The time of the injection; 2 sec.

Secondary injection molding unit:

The temperature of the mold; 60°C

The pressure of the injection; 1000 kg/cm$^2$

The temperature of the injection molding; 220°C

The time of the injection; 1.5 sec.

The resulting housing had the box form, thickness 4.5 mm, length 250 mm, width 200 mm, height 30 mm.  In the housing, the first layer (120) as the inner layer and the second layer (124) as the outer layer were strongly bonded to each other and the housing had desirable mechanical strength and insulation resistance, and further, the housing had the excellent electromagnetic shielding effectiveness and was useful for the housing of the digital instruments. Namely, the housing showed 50 dB for 100 $MH_2$ of the electromagnetic wave in the electromagnetic shielding effectiveness.

- 19 -

CLAIMS

1. A method for the manufacture of a housing (122) having a two-layer structure, which method comprises injection-molding a first layer (120) from a composition comprising at least one thermoplastic resin and at least one metal filler and then injection-molding a second layer (124) from a composition comprising at least one thermoplastic resin but no electrically conductive filler while keeping the temperature of the first layer at a temperature within $30^{\circ}C$, above or below, of the softening point.

2. A method according to claim 1, wherein said metal filler comprises metal fiber having a diameter from 5 to 100 micrometres and a length from 1 mm to 10 mm.

3. A method according to claim 1 or 2, wherein said metal filler comprises pultruded fibers.

4. A method according to claim 3, wherein a fixed number of metal fibers are bundled, elastomer is coated on the circumference of said bundle and the resulting coated bundle is cut to a fixed length to provide said filler.

5. A method according to claim 1 wherein said metal filler comprises metal flake having shortest dimension and longest dimension from 0.5 mm to 3 mm, respectively, and a thickness from 10 to 100 micrometres.

## FIG.1

105 116 111 109 102
104 114 107 101
106 103

## FIG.2

116 115 112A 117 110 112A 108
114 111 107
106 109 103

121 112A 118 112A 113
119 123 120 118 112

2/2

FIG.3

122

124

123    120A    120A    120